# EUROPEAN PATENT APPLICATION

(11) **EP 1 622 205 A2**
(43) Date of publication of application: **01.02.2006**
(21) Application number: 05009463.0
(22) Date of filing: 29.04.2005
(51) Int. Cl.: H01L 31/0232, H01L 31/0203, H01L 33/00, H01S 5/022

(54) **Electronic package incorporating electronic components generating and/or receiving light-based signals**

(30) Priority: 29.07.2004 EP 04017977
(71) Applicant: Schott AG, 55122 Mainz (DE)
(72) Inventor: Bhosale, Rohit, 84028 Landshut (DE)
(74) Representative: Fuchs Mehler Weiss & Fritzsche

(57) **Abstract**

An electronic package is proposed incorporating electronic components generating and/or receiving light-based signals and optical elements, the electronic components being encapsulated by a sealing-off housing (1).

It is proposed that the optical elements (2) for transceiving the signals are Diffractive/Refractive Optical Elements (D/ROE's) which form parts of the sealing-off measures of the housing (1). Accordingly, the D/ROE's have optical and sealing-off functions.

## Description

### Background of the invention

### Field of the invention

The invention relates to an electronic package incorporating electronic components generating and/or receiving light-based (visible or invisible) signals and optical elements. The pattern within the last couple of years, for example for transistor packages irrespective of the TO header has been the use of window caps with Optical Sub Assembly (OSA), which has been improved by the use of ball lens caps in different materials like glass, sapphire, quartz, silicon etc. suiting the requirements. The next stage of performance improvement was achieved by using aspheric lenses, which eliminated the linear aberration of the focus limitation of ball lenses. All the optical materials were conveniently coated with different coatings serving the applications, for instance antireflective coating, beam splitter etc.

All the optical elements in such TO caps have been traditionally sealed into metal caps, which were either machined or deep drawn or manufactured by a similar manufacturing method by different sealing processes. Other non metallic materials like ceramics are also useable based upon the application for example in Hybrid packages. Sealing processes vary per user from glass to metal seal, metallization or soldering or any other process which glued the optical element to the cap or the hybrid housing. The cap can be made out of any material like metal, ceramic, plastic etc.

Said cap with the optical elements is mounted on, e.g. a transistor outline header, or a hybrid package with optical window, both of which have an active or passive device needing packaging and is sealed by a suitable method. The optical element acts as the important part in the current assembly as it functions in channelling the output from the device in use in the right way. The same applies for devices receiving light signals. The package could be hermetic, semi-hermetic or non-hermetic as per the requirement of the application.

Consideration is drawn to the packaging of a laser device for a transceiver application, in which a laser device is mounted on a TO header along with other required electronics. This laser device would require a hermetic packaging for longer lasting life along with optimal performance. The requirement of the package is to bring in electrical connections and take the optical output from the device into a coupling object or device.

In most cases after the assembly of the device on the TO header is completed a TO cap with an optical element such as a ball lens is used. The ball lens is used to channel the output of the laser device into a fibre. The ball lens is usually sealed in the metal can with glass solder or glass frit. This TO cap after assembly is then sealed onto the TO header with any suitable method, e.g. by seam welding or projection welding. Once the complete assembly of header and cap is finished, the device is started electrically and the output of the laser along with an OSA is channelled into a fibre.

Such an electronic package is known from GB 2 360 656 A. This document discloses a transceiver using diffractive optical elements to direct the beams. The transceiver includes a transmitter for outputting a plurality of beams of electromagnetic energy. The transmitter is a vertical cavity surface emitting laser. A plurality of beams output by the transmitter are directed to a detector by an array of diffractive optical elements (DOE's). Preferably the optical elements are fabricated by imprinting a pattern high temperature film substrate using an ultraviolet epoxy. The use of a vertical cavity surface emitting laser is supposed to allow for high data rates while the diffractive optical element allows for a compact design. However, the design of the transceiver is still quite complicated and thus expensive. Nowadays requirements, however, are to manufacture electronic packages as cost-effective as possible at highest qualities.

### Summary of the invention

Accordingly it is an object of the invention to provide an electronic package incorporating electronic components generating and/or receiving light-based signals and optical elements, which overcomes the above-mentioned disadvantages of the heretofore known packages of this general type, which can be produced at low costs.

With the foregoing and other objects in view there is provided in accordance with the invention an electronic package of the above described type, wherein the optical elements for transceiving the signals are Diffractive/Refractive Optical Elements (D/ROE) or arrays of D/ROE's which perform parts of the sealing-off measures. The D/ROE's could be as simple as concentric rings or as complicated as arrays of diffractive optical structures or a holographic pattern, which are all, generated with computer aided programs. Other combinations of refractive and diffractive lenses are possible to generate the desired performance.

The key of the invention is the double-function of the D/ROE's. They not only provide excellent optical characteristics but they also take part in the sealing function. The entire process of the sealing remains the same as in the prior art or any other suitable ways could be implemented. The improvement lies in the form of efficiency and cost savings. Using D/ROE's different patterns, geometries can be created on one side or both sides of an optical glass disc, plano-convex, plano-concave or any other lens for beam pointing or collimation. Other optical purposes are possible. In case of beam pointing the invention is advantageous as it can potentially replace ball lenses used in the prior art packages. D/ROE's can be utilized to create structures on a substrate of any material to work as an aspheric lens, ball lens or any other optics. The realization of such structures can be achieved by any of the standard micro structuring process or any other processes established for creating microstructures. Certain examples can be glass micro structuring on glass or silicon, silicon microstructures on silicon using lithography or hot embossing or any other suitable process. The structuring process can be accomplished individually or on a wafer scale. Wafer scale reproduction of such structures is preferred as it helps to bring costs down. Also, by using this process on wafer scale the inspection step of the structures can also be done prior to dicing along with marking for bad structures, thus increasing the yield. The structures can be cut into individual discs or any other shape with an appropriate separation method. These individual structured substrates can then be sealed with glass- to metal-sealing, solder sealing or other appropriate sealing techniques to create a hermetic or semi-hermetic seal into a cap of the electronic package for further use.

According to a preferred embodiment of the invention the D/ROE's are placed and fixed within a window in the cap of the package. The D/ROE's play their role as part of the sealing-off of the package in so far as dimensions can be chosen in such a way that the sealing area against the cap of the package is extremely enlarged as compared to the prior art cases where ball lenses have to be placed into windows in the cap and sealed off.

As already mentioned if the cap is made out of metal the D/ROE's are preferably fixed within the cap by glass-to-metal sealing techniques (GTMS).

The present invention also claims the use of D/ROE's as sealing off members in a cap for an electronic package incorporating electronic components generating and/or receiving light-based signals. Heretofore the double function of D/ROE's as excellent optical components and parts of sealing-off members of electronic packages is not known.

### Brief description of the drawings

The invention will be illustrated in comparison to the known standard TO cap with an optical element using a ball lens. Therefore,
- Fig. 1: shows a diagrammatic sectional view of a prior art TO cap with a ball lens as optical element
- Fig. 2: an example of a TO cap according to the present invention.
- Fig. 3: a detailed view of the optical element with diffractive optical element on one side
- Fig. 4: a detailed view of the optical element with diffractive optical element on both sides
- Fig. 5: a detailed view of the optical element with a diffractive optical element and refractive optical element as a combination, and
- Fig. 6: different types (a, b, c) of diffractive optical elements

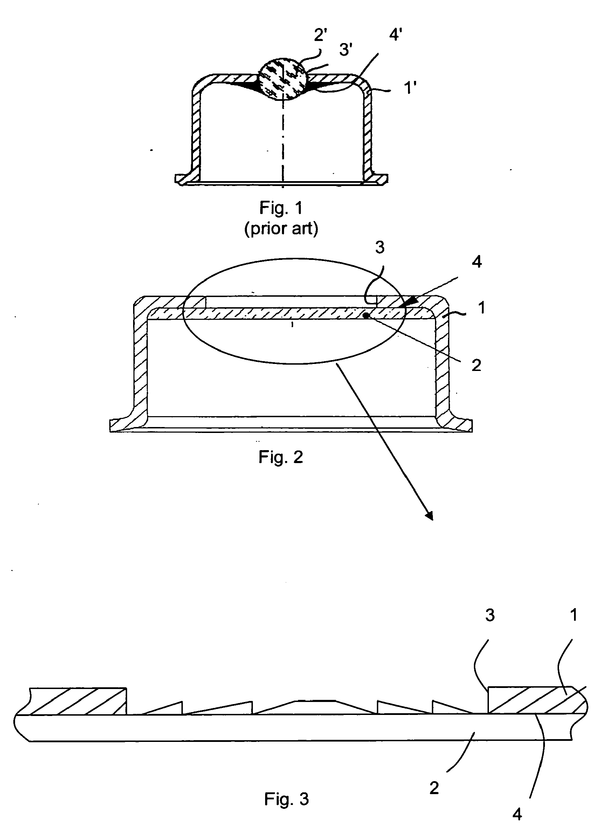

Referring now to figure 1 a conventional TO cap 1' is shown with a window 3'. Within the window 3' is located an optical element 2', in the illustrated case a ball lens. The cap 1' is sealed off by a glass-to-metal seal 4'. Manufacturing of seal 4' in the prior art is quite complicated besides the fact that optical elements 3' in the form of ball lenses are quite expensive.

Attention is now drawn to figure 2 showing a diagrammatical sectional view of an example for a TO cap of an electronic package according to the present invention. As in the prior art case the cap has a window 3. Window 3 is sealed off by D/ROE's 2. As becomes apparent from the diagrammatical view the sealing area 4 is much larger as compared to the prior art case. D/ROE 2 is simply set into the bottom of cap 1 and sealed thereto using any suitable method.

Turning now to figure 3 a detailed view of an exemplary optical element 2 is displayed sealing-off a window 3 in the housing 1 within the sealing area 4. In figure 3 the optical element 2 is a one-sided diffractive optical element.

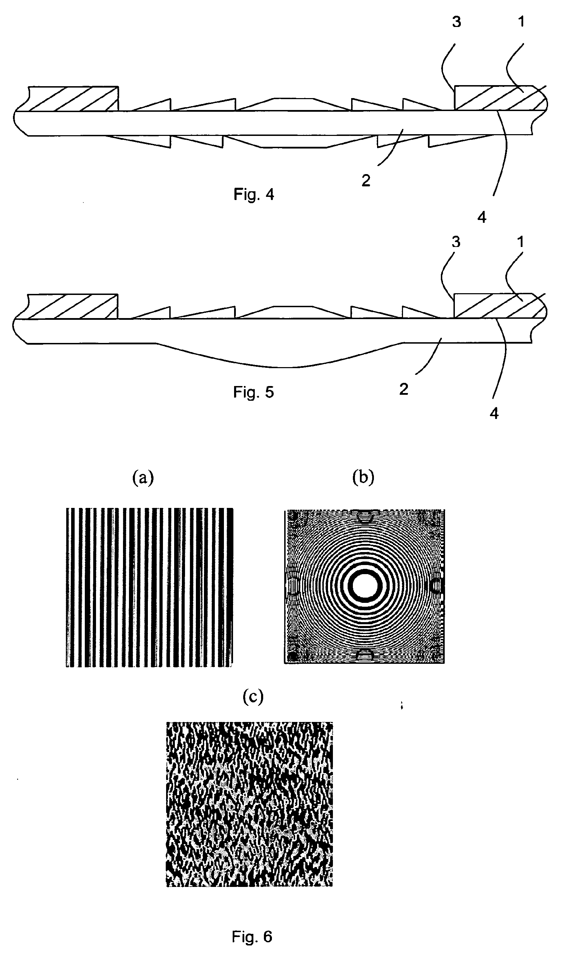

Figure 4 shows a similar view as figure 3. In this very case, however, the optical element 2 is a two-sided diffractive optical element.

Figure 5 is a detailed view of another embodiment of the optical element 2. The optical element 2 has on one side, in figure 5 the upper side, diffractive structures and on the other side a refractive optical element. Accordingly, the optical element 2 according to figure 5 incorporates a combination of diffractive and refractive elements.

Finally figure 6 shows different types of diffractive optical elements. In figure 6a a linear optical element is shown, whereas in figure 6b a circular element is shown. In figure 6c a computer generated hologram is shown exemplary which might form a diffractive optical element on the upper or on the lower side of the optical element 2.

The present invention provides for an electronic package and use of D/ROE's in such packages in order to create a hermetic, semi-hermetic or quasi-hermetic bond between the substrate or the carrier of the structure to the carrier of the optical element which in most of the cases are metal cans, to be used in packaging technologies such as transistor packages, hybrid packages, ceramic packages or similar techniques requiring optical elements with such bond along with the required optical functions to optimise the output.

## Claims

1. Electronic package incorporating electronic components generating and/or receiving light-based signals and optical elements, the electronic components being encapsulated by a sealing-off housing (1), wherein the optical elements (2) for transceiving the signals are Diffractive/Refractive Optical Elements (D/ROE's) or arrays of D/ROE's which form part of the sealing-off measures.

2. Electronic package according to claim 1, wherein the optical elements (D/ROE's) (2) are piano-convex, plano-concave or planar-structures.

3. Electronic package according to claim 1 or 2, wherein the optical elements (2) are designed to act as beam-pointers.

4. Electronic package according to claim 1 or 2, wherein the optical elements (2) are designed to act as collimators.

5. Electronic package according to claim 1 or 2, wherein the optical elements (2) are designated to act as special coatings e.g. beam splitters.

6. Electronic package according to any preceding claim, wherein the optical elements (2) are placed and fixed within windows (3) in the housing (1).

7. Electronic package according to claim 6, wherein the optical elements (2) are fixed within the windows (3) in the housing (1) by any suitable method.

8. Electronic package according to claim 7, wherein the housing (1) is made out of metal and the D/ROE's are fixed within the housing (1) by glass-to-metal-sealing techniques (GTMS).

9. Use of Diffractive/Refractive Optical Elements (D/ROE's) (2) as sealing off members in a housing (1) for an electronic package incorporating electronic components generating and/or receiving light-based signals.
